# EUROPEAN PATENT APPLICATION

(11) **EP 2 154 726 A2**
(43) Date of publication of application: **17.02.2010**
(21) Application number: 09161457.8
(22) Date of filing: 29.05.2009
(51) Int. Cl.: H01L 29/872, H01L 29/06, H01L 21/04, H01L 29/24

(54) **A method for producing a JBS diode**

(30) Priority: 14.08.2008 SE 0801792
(71) Applicant: Acreo AB, 164 40 Kista (SE)
(72) Inventor: Bakowski, Mietek, 472 92 Stillingsön (SE); Ericsson, Per, 175 67 Järfälla (SE); Schöner, Adolf, 165 74 Hässelby (SE)
(74) Representative: Olsson, Jan

(57) **Abstract**

A method for producing a junction barrier Schottky diode (JBS) of a wide band gap semiconductor material comprises the steps of epitaxially growing on top of each other: a substrate layer (1) being highly doped according to a first conductivity type, a first drift layer (2) being low doped according to said first conductivity type, and a layer (3) of a second conductivity doping type. It is then locally etched through said second conductivity type layer at least to the first drift layer (2) while leaving emitter layer regions (4) spaced on top of the first drift layer. A second drift layer (6) is then epitaxially grown on top of the emitter layer regions and the first drift layer.

## Description

### TECHNICAL FIELD OF THE INVENTION AND BACKGROUND ART

The present invention relates to a method for producing a junction barrier Schottky diode (JBS) of a semiconductor material having a band gap between the conduction band and the valence band thereof exceeding 2 eV.

A junction barrier Schottky diode and a method for production thereof are known through for instance US patent 6 104 043.

Such a junction barrier Schottky diode is manufactured in an attempt to combine properties of a Schottky diode and of a bipolar diode. The advantage of a Schottky diode is the fast switching from conducting to blocking states and the low potential barrier thereof resulting in low conduction losses. However, a disadvantage of a Schottky diode is a comparatively low voltage blocking capability and high leakage currents. The low barrier of a Schottky diode makes the temperature properties thereof unfavourable, since this low barrier results in high leakage currents. It is for sure possible to improve these temperature properties of a Schottky diode by using a metal layer forming the Schottky contact to the semiconductor material of the diode so that the potential barrier to the semiconductor material is increased, but that would then result in degraded conducting properties.

The advantage of a bipolar diode with respect to a Schottky diode is a possibility to withstand substantially higher blocking voltages and the low leakage currents thereof as a consequence of the higher potential barrier of the pn-junction thereof. This results in leakage currents being several orders of magnitude lower than for a Schottky diode. However, the bipolar diode is associated with rather high losses when switching from conducting to blocking state. Another advantage of bipolar diode with respect to a Schottky diode is its ability to withstand short pulses of high current so-called surge current capability.

This all together means that a combination of a Schottky diode and a bipolar diode as in a junction barrier Schottky diode is attractive, since in this type of diode the diode will at forward voltages well below the built-in potential of the pn-junction act as a Schottky diode conducting higher currents at lower voltage drop and thereby having lower on-state losses. Thus, it relies on transport across the Schottky barrier in the forward direction, while in the blocking state the depletion regions of the pn-junction formed by emitter layer regions of such a diode will join each other, pinching off the Schottky region and exposing it only to a low field even at high reverse bias voltages resulting in acceptably low leakage currents also at such high reverse bias voltages due to the pn-type behaviour in the blocking state. Another advantage of a combination of a Schottky diode and a bipolar diode is that at forward voltages in excess of the built-in potential of the pn-junction the diode current will flow also through the bipolar junction regions thus reducing the forward voltage compared to that of a Schottky diode at high current densities. This is especially advantageous when the diode is subjected to high current pulses so-called surge currents.

Although such junction barrier Schottky diodes already known are well functioning and in some applications favourable with respect to Schottky diodes and bipolar diodes there is of course an ongoing desire to improve the properties of junction barrier Schottky diodes, especially since they are key components in power electronic systems.

### SUMMARY OF THE INVENTION

The object of the present invention is to provide a method for producing a junction barrier Schottky diode making it possible to manufacture such diodes being improved in at least some aspect with respect to such diodes already known.

This object is according to the invention obtained by providing a method of the type defined in the introduction comprising the steps of:
a) epitaxially growing on top of each other the following semiconductor layers of said semiconductor material: a buffer layer being highly doped according to a first conductivity type, n or p, a first drift layer being low doped according to said first conductivity type, and a highly doped emitter layer of a second conductivity type, n or p, opposite to the first conductivity type,
b) locally etching through said second conductivity type layer at least to the first drift layer while leaving emitter layer regions laterally spaced on top of said first drift layer and forming windows in said emitter layer,
c) epitaxially growing in said windows and on top of said emitter layer regions and said first drift layer a second drift layer being low doped according to said first conductivity type, and
d) applying a metal layer on top of said second drift layer to make a Schottky contact thereto and in contact with at least one of said emitter layer regions to make an ohmic contact thereto.

A junction barrier Schottky diode produced through such a method and called EBS (Epitaxial Bipolar Schottky) will be particularly suited where excellent high temperature properties are required. By combining the technologies of epitaxy, etching and regrowth for realizing emitter layer regions buried in a drift layer (first and second drift layers) said emitter layer regions with a high crystalline quality may be produced that are free from implantation damage. This results in better injection efficiency of such an emitter layer and in leakage currents being at least one order of magnitude lower than in known junction barrier Schottky diodes of wide band gap materials (the gap between the conduction band and the valence band exceeding 2 eV), in which the emitter layer regions have been produced by implantation. Thus, the surge current capability and the high temperature properties of the EBS diode produced through the method according to the present invention are superior to those of known such JBS diodes.

Other advantage of utilizing epitaxy for producing said emitter layer regions is that there is no limitation to the thickness of the emitter layer regions that can be produced compared to the implanted emitter layer which is practically ≤ 1 µm thick and typically ≤ 0.5 µm. This results in a number of important advantages. One is larger tolerances when etching contact holes to the said emitter layer, which means that it is not that delicate to etch down to thicker such emitter layer regions for obtaining said ohmic contact thereto, so that the thickness may be selected so that such etching may easily take place without any risk of over-etching and causing damage to the emitter layer. Second is a freedom of using a thicker second drift region and still being able to etch down contact holes to the said emitter region with good control as explained above. The thicker second drift region makes shielding of the Schottky barrier region from the electric field very efficient making possible a reduction of leakage current by 3 to 4 orders of magnitude and an expansion of the operational temperature range of the device above at least 250°C, most probably 450°C and ideally 600°C. The effective shielding of the Schottky barrier region from the electric field also makes it possible to choose a metal with lowest possible Schottky barrier, desirably ≤ 1eV (like for instance Ta), and thus reducing the on-state voltage without increasing the leakage current and without sacrificing the operational temperature range of the device.

According to an embodiment of the invention the etching in step b) is carried out so as to form laterally extending bars of emitter layer regions crossing each other and forming a bar pattern, and in step d) said metal layer is applied on top of the bar pattern to form an ohmic contact thereto at selected locations. The formation of such a bar pattern will make it possible to conveniently establish the ohmic contact at locations having a comparatively large mutual distance making the requirements of the processing steps lower.

According to another embodiment of the invention the etching in step b) is carried out so as to form windows in the emitter layer in the form of rectangles ordered in parallel, squares, circles or hexagons.

According to another embodiment of the invention the etching in step b) is carried out so as to form islands of emitter layer in the form of rectangles, squares, circles or hexagons.

The hexagonal and linear-parallel (rectangles) structures are favourable, since the hexagons may be arranged with the same distance to an adjacent hexagon all around the hexagon and the rectangles may be arranged with the same distance to an adjacent rectangle along the long side of the rectangle.

All the patterns described above are cellular which means they can be built by repetition of a unit cell characteristic for each pattern. Several cells can be combined into a segment and the entire pattern will then be built of repetitions of segments. The segment contains minimum one cell. The ohmic contact formed in the step d) can be provided to each unit cell or only to the segment by arranging it at the periphery of each segment.

According to another embodiment of the invention said first drift layer is in step a) grown with a doping concentration being reduced in a substantially vertical direction of growth and/or said second drift layer is in step c) grown with a doping concentration being reduced or increased in a substantially vertical direction of said growth. The result of this will in the reverse biased state of the diode be a larger depleted region closest to the metal layer electrode making the shielding of the Schottky contact easier, since a depleted region extending between adjacent emitter layer regions will be formed earlier, i.e. at a lower voltage.

According to another embodiment of the invention said second drift layer is in step c) grown with a lower doping concentration than said first drift layer, which constitutes a very simple way to realise the previous embodiment of the invention.

According to another embodiment of the invention SiC is epitaxially grown as said semiconductor material in steps a) and c). The excellent physical properties of SiC are well known: high thermal stability, high thermal conductivity and high breakdown field making SiC well suited as a material for high power devices operating under conditions where high voltages may occur in the blocking state of the device.

According to a further embodiment of the invention GaN is epitaxially grown as said semiconductor material in steps a) and c). GaN is also a wide band gap semiconductor material well suited to be used in a junction barrier Schottky diode.

According to another embodiment of the invention said first conductivity type is n. This is especially advantageous when SiC is the semiconductor material as a consequence of the higher mobility of electrons than holes in SiC.

According to another embodiment of the invention it is a junction barrier Schottky diode designed with a reverse voltage blocking capacity of 300 V - 10 kV, preferably 600 V - 3.3 kV that is produced. Such a diode well suited for high power electronic equipment can be produced in this way.

According to another embodiment of the invention said spacing between adjacent said emitter layer regions is 1 µm-8 µm, preferably 2 µm - 6 µm. The higher the reverse voltage blocking capacity of the diode the lower doping concentration in the drift layers thereof resulting in a possibility to increase said spacing.

According to another embodiment of the invention SiC is epitaxially grown as said semiconductor material in steps a) and c), and said first and second drift layers are grown with a doping concentration of 2·10¹⁴-5·10¹⁶ cm⁻³, preferably 1·10¹⁵-2·10¹⁶ cm⁻³. These are suitable doping concentrations when using SiC for said drift layers.

According to another embodiment of the invention SiC is epitaxially grown as said semiconductor material in steps a) and c), and said second conductivity type layer is grown with a doping concentration of 10¹⁶-10²⁰ cm⁻³, preferably 10¹⁸-5·10¹⁹cm⁻³. These are suitable doping concentrations for the emitter layer regions for obtaining an efficient shielding of the Schottky contacts in the reverse biased state of the diode with a said spacing being large enough for obtaining attractively low conduction losses of the diode.

Further advantages as well as advantageous features of the invention will appear from the following description.

### BRIEF DESCRIPTION OF THE DRAWINGS

With reference to the appended drawings, below follows a specific description of an embodiment of the invention cited as an example.

In the drawings:
- Fig. 1-4: are schematic cross-section views illustrating different steps of a method according to an embodiment of the invention for producing a Junction Barrier Schottky diode (JBS),
- Fig. 5: is a perspective view from above of a JBS produced by carrying out the method illustrated in Figs. 1-4 with portions broken away for illustrating the structure of the diode, and
- Figs 6-12: show schematic top views of different discussed buried emitter patterns, showing unit cells and the ways of creating a segmented design in order to be able to provide electrical connection to each unit cell by creating an ohmic contact only to the segment containing more than one unit cell.

### DETAILED DESCRIPTION OF AN EMBODIMENT OF THE INVENTION

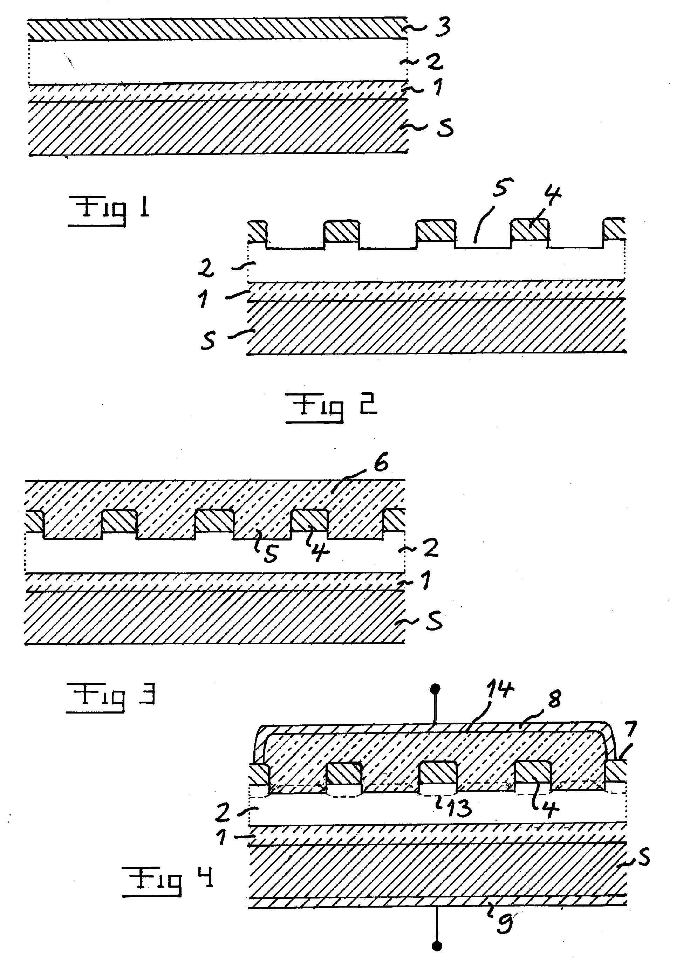

A method for producing a Junction Barrier Schottky diode (JBS) of SiC according to an embodiment of the invention will now be described while simultaneously referring to Figs. 1-4. These figures very schematically illustrate different layers of such a diode, in which the relationship of the dimensions of different layers are not drawn to scale, but the drawings are merely intended to explain the structure of the diode.

The method is started by epitaxially growing on top of the highly doped n-type substrate S, preferably by Chemical Vapor Deposition, the following layers of SiC: a highly doped n-type, buffer layer 1, a low doped n-type first drift layer 2 and a highly doped p-type emitter layer 3. Any suitable donor, such as nitrogen and phosphor, are used for the substrate layer and the first drift layer, whereas a suitable p-typed dopant, such as boron or preferably aluminium, are used as acceptor for the layer 3. Typical doping concentrations may be 10¹⁵-2·10¹⁶ cm⁻³ for the first drift layer 2 and 5·10¹⁸-10¹⁹ cm⁻³ for the substrate and 5·10¹⁷ -2·10¹⁸ cm⁻³ for the buffer layer 1. The doping concentration for the layer 3 is typically 10¹⁸-5·10¹⁹ cm⁻³.

After applying a suitable mask on top of the p-type emitter layer 3 and appropriate patterning thereof windows 5 are etched through the layer 3 to the first drift layer 2 as illustrated in Fig. 2 while leaving emitter layer regions 4 laterally spaced and separated by the said windows on top of the first drift layer 2. A number of different patterns, built up by the repetition of unit cell pattern consisting of the etched window and the surrounding p-type emitter layer, are possible depending on the geometrical shape of the etched windows 5 and called here linear-parallel, square, circular and hexagonal patterns, with most preferred being linear-parallel and hexagonal ones. Several unit cells can be combined into a segment. The smallest number of cells per segment is one cell. The etching depth is one of the parameters of the method.

After removal of said mask a second n-type low doped drift layer 6 is then epitaxially grown on top of the emitter layer regions 4 and in the windows 5 and on top of the first drift layer between these regions 4 for forming emitter layer regions buried in drift layers as shown in Fig. 3. The doping concentration of the second drift layer may be the same as that of the first drift layer, but it may also be another and is preferably lower and may even be reduced in the direction of said growth for obtaining the advantages mentioned above.

Contact holes 7 to the buried emitter layers are then etched in order to provide an ohmic contact to each segment in such a way as to limit the resistance to each unit cell and preferably along the perimeter of each segment or directly to each of the individual emitter cells, as shown in Fig. 4. After surface passivation and patterning a metal layer 8 is applied on top of the drift layer 6 to make a Schottky contact thereto and in contact with the emitter layer regions. The metal used for the Schottky contact may for instance be Ti resulting in a Schottky barrier of about 1.25 eV.

The arrangement of a metal contact 9 to the opposite side of the diode is also shown in Fig. 4. In the case of an insulating substrate the contact 9 must be arranged to the buffer layer 1 from the top side of the diode.

It is pointed out that layers, such as passivation layers, having nothing to do with the present invention have been left out in the figures for better explaining the invention.

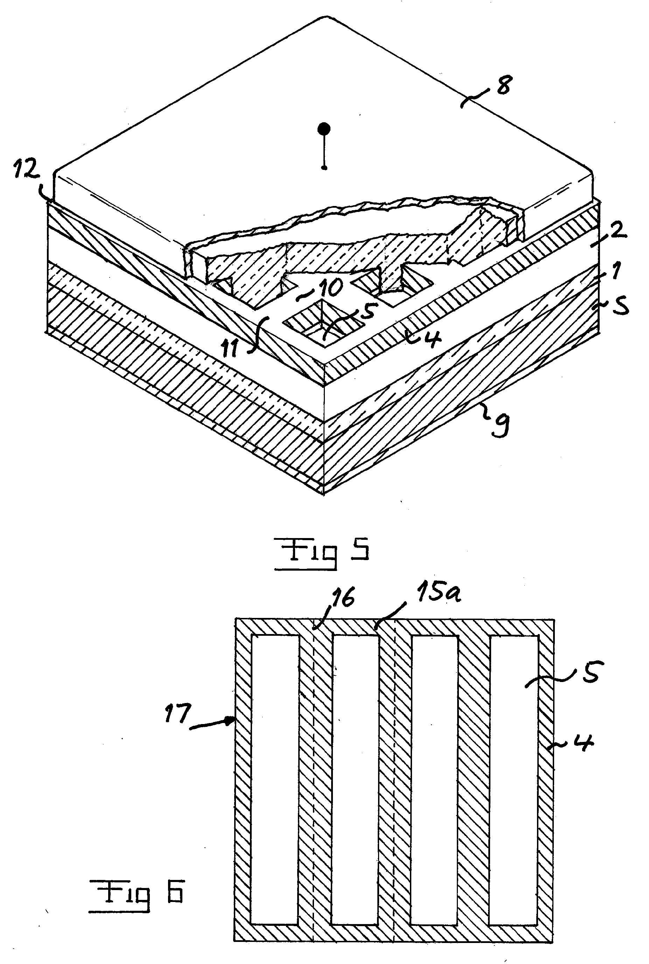

It is shown in Fig. 5 how the etching of square windows through the layer 3 has been carried out for forming laterally extending bars 10 of emitter layer regions crossing each other and forming a bar pattern 11 and a square cell pattern. It is also shown how the metal layer 8 forms an ohmic contact to the emitter layer regions 4 at the perimeter 12 of the segment containing 16 square cells. It is shown as well how the square unit cells are combined into a segment surrounded by a contact to the emitter layer regions 4.

The function of a diode shown in Figs. 4 and 5 is obvious to a person with ordinary skill in the art, but it will in any way be briefly explained. In the forward conducting state of the diode it will due to the lower Schottky barrier (about 1.25 V) than the pn-barrier (about 2.5 V) function as a Schottky diode at lower current densities, so that the on-state losses will be lower than for a pn-diode. There will also at such lower current densities be no injection of minority charge carries from the emitter layer regions 4 into the drift layer, which means that switching losses due to reverse recovery charge will be negligible. At high enough current densities minority charge carriers will be injected from the emitter layer regions into the drift layer and the characteristic of the diode will come closer to that of a pn-diode. This is an advantage for the surge current capability of the device. In the reverse blocking state of the diode, accordingly, when the metal layer 8 is connected to a negative potential, the depletion region will be formed at the junction between the emitter layer regions and the drift layer regions 2, 6 and due to their low doping these regions will be easily depleted and a continuous depleted region will form the windows 5 and under the emitter regions 4, as indicated by the dashed line 13 in Fig. 4. This means that the diode will get the character of a conventional pn-diode and the field concentrations will be at the pn-junction and kept away from or reduced at the Schottky contact 14.

Calculations show that when applying a reverse bias voltage of 600 V to a diode according to the present invention having 1.5 µm thick second drift layer 6 the electric field under the Schottky contact 14 is 2·10⁵ V/cm compared to 2·10⁶ V/cm for a corresponding diode produced by using the implantation technique for producing the emitter layer regions. This means that the leakage current will in the diode according to the present invention be of the same order as for a pure pn-junction. The value of the electric field can be further reduced by making the drift layer 6 thicker which makes it possible to use the Schottky metal with lower energy barrier and thus improving the on-state properties without increasing the leakage current or sacrificing the operational temperature range of the device.

Advantages of a Junction Barrier Schottky diode (JBS) produced through a method according to the present invention are an extremely low leakage current due to the efficient shielding of the Schottky barrier from the electric field, a high temperature operation comparable to that of pn junction silicon carbide diode, reduced on-state losses since it allows the use of lower Schottky barrier metal without sacrificing the high temperature capability and a high surge current capability, since it may take short current pulses being at least 10 times higher than the nominal current. This corresponds to the following advantages at system level: a better efficiency by lower losses, a higher power density, i.e. a higher power/volume ratio, higher frequencies and reduced cooling requirements due to lower losses.

This results in its turn in the following advantages at application level: physically smaller units with lower weight, simplified cooling and lower audible noise levels.

Fig 6 is a top view of an alternative design of said windows 5, which here have a rectangular shape and are surrounded by emitter layer regions 4 in the form of bars for forming rectangular cells 15a consisting each of a window 5 and part of the surrounding emitter layer region 4 as indicated through the dashed line 16. The unit cells are combined into a segment 17, to which contact may be made at any location for making contact to all emitter layer regions included in the segment.

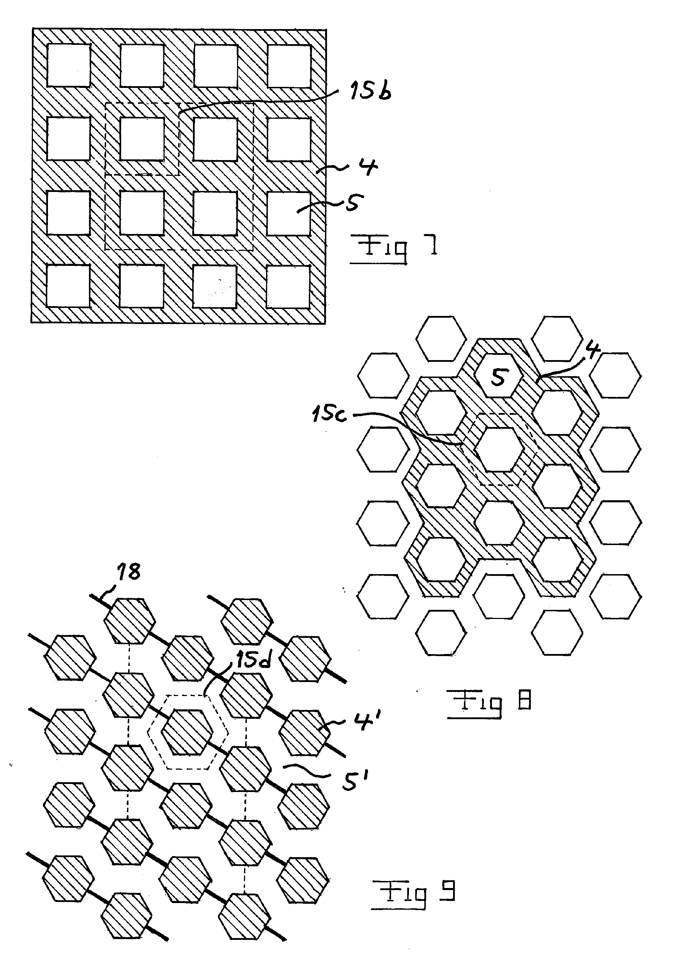

Fig 7 is a view similar to Fig 6, in which the windows 5 are squares, as shown in Fig 5. A unit cell is indicated by 15b.

Fig 8 shows windows 5 in the form of hexagons and how a unit cell 15c is defined.

Fig 9 shows how islands 4' of emitter layer regions may be formed, in this embodiment with a hexagonal shape while being surrounded by said windows 5', which are here only partially surrounded by emitter layer regions 4'. It is shown how a unit cell 15d is formed by a hexagonal emitter layer region 4' and parts of a window surrounding it. It is also shown how emitter layer regions 4' are in rows electrically connected to each other (18), and an ohmic contact may be obtained to all the cells of such a row by making contact to any cell of the row. Thus, the embodiment according to Fig 9 is inverted with respect to the embodiment in Fig 8. An advantage of the hexagonal shape is that the distance of a hexagon to adjacent hexagons will be the same around the entire periphery of the hexagon.

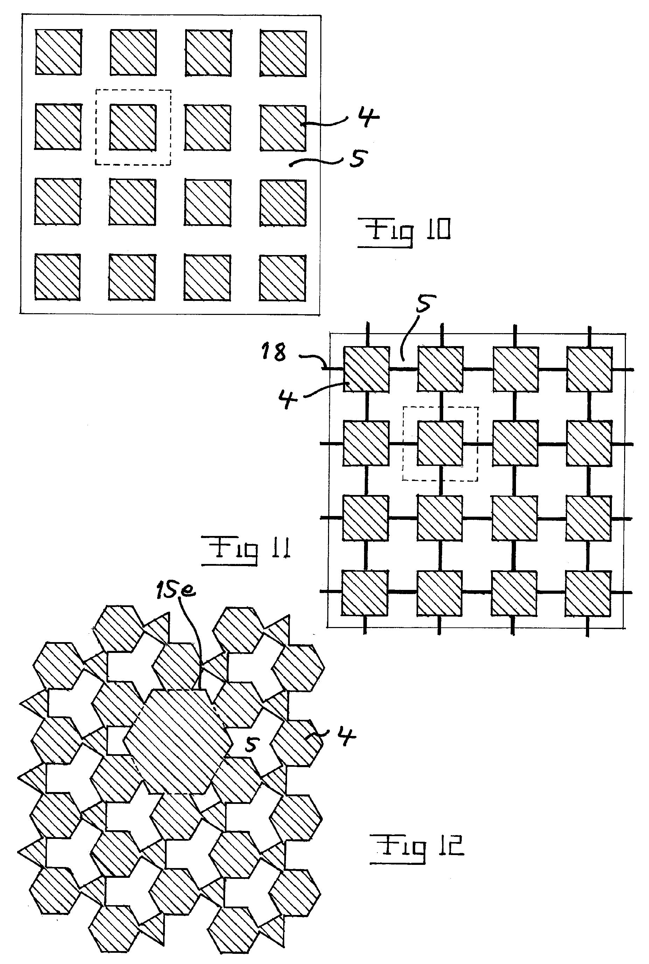

Fig 10 and Fig 11 show in a similar way a structure being inverted with respect to the structure shown in Fig 7, so that the emitter layer regions are here formed by square islands, in which the contact making thereto is illustrated in Fig 11.

Finally, Fig 12 shows an alternative structure with an hexagonal pattern having a somewhat larger contact cell 15e, through which contact is made to all the other smaller cells with a hexagonal shape included in the segment shown in Fig 12.

The invention is of course not in any way restricted to the method according to the embodiment described above, but many possibilities and modification thereof would be apparent to a person with ordinary skill in the art without departing from the basic idea of the invention as defined in the appended claims.

It is for instance possible to carry out the etching in step b) further than just to the first drift layer for forming cavities or pockets therein, which may then in the regrowth step c) be filled with material having a lower doping concentration than surrounding first drift layer portions for making the drift layer portions separating the emitter layer regions more easily depleted.

Other semiconductor materials than SiC are conceivable, such as particularly GaN.

"Low doped" as used for the drift layer (first and second drift layers) means a doping concentration being at least one order of magnitude, preferably at least 1.5 order of magnitude, lower than the doping concentration of the second conductivity type layer.

"Windows" is to be interpreted as an opening through the emitter layer reaching the drift layer thereunder and at least partially surrounded by emitter layer regions.

## Claims

1. A method for producing a junction barrier Schottky diode of a semiconductor material having a band gap between the conduction band and the valence band thereof exceeding 2 eV comprising the steps of:
a) epitaxially growing on top of each other the following semiconductor layers of said semiconductor material: a buffer layer (1) being highly doped according to a first conductivity type, n or p, a first drift layer (2) being low doped according to said first conductivity type, and a highly doped emitter layer (3) of a second conductivity doping type, n or p, opposite to the first conductivity type,
b) locally etching through said second conductivity type layer (3) at least to the first drift layer (2) while leaving emitter layer regions (4) laterally spaced on top of said first drift layer and forming windows (5) in said emitter layer (3),
c) epitaxially growing in said windows (5) and on top of said emitter layer regions (4) and said first drift layer a second drift layer (6) being low doped according to said first conductivity type, and
d) applying a metal layer (8) on top of said second drift layer (6) to make a Schottky contact thereto and in contact with at least one of said emitter layer regions (4) to make an ohmic contact thereto.

2. A method according to claim 1, **characterized in that** the etching in step b) is carried out so as to form windows (5) in the said emitter layer (3) forming a cellular pattern of unit cells consisting each of a window (5) and part of the surrounding emitter layer region (4), and that in step d) said metal layer (8) is applied on top of the cellular pattern to form an ohmic contact to the said emitter layer regions (4) at selected locations.

3. A method according to claim 1, **characterized in that** the etching in step b) is carried out so as to form windows in the emitter layer in the form of a) rectangles ordered in parallel, b) squares, c) circles or d) hexagons.

4. A method according to claim 1, **characterized in that** the etching in step b) is carried out so as to form islands of emitter layer regions (4) in the form of rectangles, squares, circles or hexagons, forming a cellular pattern of unit cells consisting each of an emitter layer region (4) and part of the surrounding window (5) in the emitter layer (3), and that in step d) said metal layer (8) is applied on top of the cellular pattern to form an ohmic contact to the said emitter layer regions (4) at selected locations.

5. A method according to claim 2 or 4, **characterized in that** several unit cells are combined into a segment so that the entire cellular pattern is built of the repetition of segments.

6. A method according to claim 5, **characterized in that** the ohmic contact formed in the step d) is provided only to the segment by arranging it at the periphery of each segment.

7. A method according to any of claims 2 and 4-6, **characterized in that** the ohmic contact formed in the step d) is provided to each one of the unit cells in the cellular pattern.

8. A method according to any of the preceding claims, **characterized in that** in step a) said first drift layer (2) is grown with a doping concentration being reduced in a substantially vertical direction of said growth and/or in step c) said second drift layer (6) is grown with a doping concentration being reduced or increased in a substantially vertical direction of said growth.

9. A method according to claim 8, **characterized in that** in step c) said second drift layer (5) is grown with a lower doping concentration than said first drift layer.

10. A method according to any of the preceding claims, **characterized in that** SiC is epitaxially grown as said semiconductor material in steps a) and c).

11. A method according to any of claims 1-9, **characterized in that** GaN is epitaxially grown as said semiconductor material in steps a) and c).

12. A method according to any of the preceding claims, **characterized in that** said first conductivity type is n.

13. A method according to claim 10, **characterized in that** it is a junction barrier Schottky diode designed with a reverse voltage blocking capacity of 300V-10kV, preferably 600V-3.3kV that is produced.

14. A method according to claim 13, **characterized in that** said spacing between adjacent said emitter layer regions (4) is 1 µm-8 µm, preferably 2 µm-6 µm.

15. A method according to claims 10 and 12, **characterized in that** said first (2) and second (6) drift layers are grown with a doping concentration of 2·10¹⁴-5·10¹⁶ cm⁻³, preferably 1·10¹⁵-2·10¹⁶ cm⁻³.

16. A method according to claims 10 and 12, **characterized in that** said second conductivity type layer (3) is grown with a doping concentration of 10¹⁷-10²⁰ cm⁻³, preferably 10¹⁸-5·10¹⁹ cm⁻³.

17. A method according to claims 10 and 12, **characterized in that** said metal layer (8) is Titanium or Tantalum.

18. A method according to claims 10 or 11 and 12, **characterized in that** said metal layer (8) is **characterized by** making a Schottky barrier to said semiconductor material of less than 2.0 eV and preferably less than 1.0 eV.
